# EUROPEAN PATENT SPECIFICATION

(11) **EP 3 414 541 B1**
(45) Date of publication and mention of the grant of the patent: **30.09.2020**
(21) Application number: 17706363.3
(22) Date of filing: 08.02.2017
(51) Int. Cl.: G01K 1/02

(54) **TEMPERATURE SENSING SYSTEM FOR ROTATABLE WAFER SUPPORT ASSEMBLY**
TEMPERATURERFASSUNGSSYSTEM FÜR EINE DREHBARE WAFER-TRÄGERANORDNUNG
SYSTÈME DE DÉTECTION DE TEMPÉRATURE POUR ENSEMBLE SUPPORT DE TRANCHE ROTATIF

(30) Priority: 08.02.2016 US 201662292614 P
(43) Date of publication of application: 19.12.2018
(73) Proprietor: Watlow Electric Manufacturing Company, St. Louis, MO 63146 (US)
(72) Inventor: NOSRATI, Mohammad, Redwood City MA 94065 (US); TOMPKINS, Timothy, B., San Jose CA 95119 (US)
(74) Representative: Delorme, Nicolas
(86) International application number: PCT/US2017/016975
(87) International publication number: WO 2017/139353

(56) References cited:
- EP-A1- 2 020 588
- JP-A- 2002 124 457
- US-A1- 2009 159 000

## Description

### FIELD

The present disclosure relates to semiconductor processing apparatuses, and more particularly to temperature sensing systems for the semiconductor processing apparatuses.

### BACKGROUND

Semiconductor processing involves various process steps performed on wafers in a processing chamber. In some of the processing steps, heaters are used to heat a wafer to be processed at an elevated temperature, e.g., in the range of 300 °C-1100 °C. The wafer is heated by placing the wafer on a heated wafer support portion. To heat the wafer support portion, the heater may be formed as an integral part of the wafer support portion, or disposed under the wafer support portion. In some processes, such as a film deposition process, the heated wafer support portion need to be rotated. Therefore, the heater may be configured to be rotatable with the wafer support portion or remain stationary when the wafer support portion rotates

Where the heater is provided under the wafer support portion, it is difficult to control the temperature of the wafer disposed on a rotating wafer support portion. First, the heat is transferred from the heater to the rotating wafer support portion primarily through radiation in a vacuum/low pressure environment of the processing chamber. A significant portion of the heat from the heater is lost to the surrounding environment. Therefore, it is difficult to estimate how much heat is needed from the heater to achieve a desired temperature change in the wafer. Second, the rotating movement of the wafer support portion makes direct temperature sensing difficult. Optical sensing/non-contact devices such as pyrometers are typically used to measure the surface temperature of the wafer at one or a few locations when the wafer rotates with the wafer support portion. The remote-temperature sensing typically does not provide desired temperature measurements across the wafer.

US 2009/0159000 A1 discloses a thermocouple disposed inside a tube of the wafer support structure. A wire is used to connect the thermocouple to an external controller and to transmit temperature signals.

JP2002-124457A discloses a temperature measuring device for measuring an in-plane temperature of a wafer W before processing the wafer W. The temperature measuring device includes a temperature measuring wafer S, a transmitting device for transmitting temperature data of the temperature measuring wafer S, and a cable connected therebetween. The temperature measuring wafer S has the same size and material as those of the wafer W to simulate the wafer W. The temperature measuring device detects the temperature of the temperature measuring wafer S (not the wafer W) after the temperature measuring wafer S is heated by a hot plate. By using the hot plate to heat the temperature measuring wafer S and by obtaining the temperature distribution of the temperature measuring wafer S, a temperature characteristic of the hot plate can be determined and corrected accordingly before the wafer W is placed on the hot plate for processing.

EP2020588 discloses a position detecting wafer S to detect position alignment of the wafer S relative to a mounting table. The position detecting wafer S is provided with an electrostatic capacitance detecting sensor for detecting an electrostatic capacitance between a reference point on the mounting table and the wafer S for position alignment of the wafer W.

### SUMMARY

In one form of the present disclosure, a semiconductor processing apparatus includes a wafer support assembly, a temperature sensor integrated in the wafer support assembly for measuring a temperature of the wafer support assembly, and a signal transmission device that wirelessly transmits a signal relating to a temperature measurement obtained by the temperature sensor to an external control module.

In said form of the present disclosure, the temperature sensing system includes a temperature sensor for obtaining temperature information, and a WiFi connectivity module for wirelessly transmitting the temperature information obtained by the temperature sensor to a control module.

In another form, a semiconductor processing system includes a processing chamber, a wafer support assembly, a heater, a heater control module for controlling the hater, a temperature sensor, and a WiFi connectivity module. The wafer support assembly includes a wafer support portion disposed inside the processing chamber and a shaft connected to the wafer support portion and extending through a wall of the processing chamber. The heater heats the wafer support portion. The temperature sensor is integrated in the wafer support portion. The WiFi connectivity module is electrically connected to the temperature sensor for wirelessly transmitting a signal relating to a temperature measurement obtained by the temperature sensor to the heater control module.

Further areas of applicability will become apparent from the description provided herein. It should be understood that the description and specific examples are intended for purposes of illustration only and are not intended to limit the scope of the present disclosure.

### DRAWINGS

In order that the disclosure may be well understood, there will now be described various forms thereof, given by way of example, reference being made to the accompanying drawings, in which:
FIG. 1 is a cross-sectional view of a semiconductor processing apparatus incorporating a temperature sensing system constructed in accordance with the teachings of the present disclosure; and
FIG. 2 is a block diagram of a temperature sensing system constructed in accordance with the teachings of the present disclosure.

The drawings described herein are for illustration purposes only and are not intended to limit the scope of the present disclosure in any way.

### DETAILED DESCRIPTION

The following description is merely exemplary in nature and is not intended to limit the present disclosure, application, or uses.

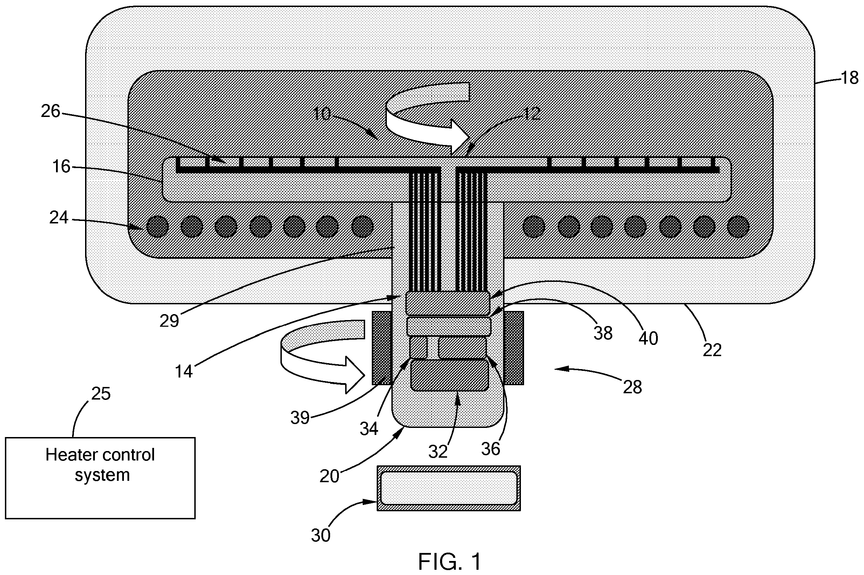

Referring to FIG. 1, a semiconductor processing apparatus according to the disclosure of the present application is generally indicated by reference 10. The semiconductor processing apparatus 10 includes a wafer support assembly 12, and a temperature sensing system 14 integrated in the wafer support assembly 12. The wafer support assembly 12 includes a wafer support portion 16 disposed in a semiconductor processing chamber 18 and a shaft 20 connected to the wafer support portion 16 and extending through a wall 22 of the semiconductor processing chamber 18. The wafer support portion 16 may be a susceptor, an electrostatic chuck or any support means that can support a wafer to be processed thereon. The shaft 20 is connected to an external rotating means (not shown) outside the semiconductor processing chamber 18. The external rotating means drives the wafer support assembly 12 to rotate in the semiconductor processing chamber 18.

The semiconductor processing apparatus 10 further includes a heater 24 disposed under the wafer support portion 16 to heat the wafer support portion 16 and the wafer (not shown) disposed thereon. The heater 24 is controlled by a heater control system 25 provided outside the processing chamber 18. The heater 24 may be a tubular heater.

The temperature sensing system 14 includes a plurality of temperature sensors 26 integrated in the wafer support portion 16, a sensing control unit 28 connected to the temperature sensors 26 through a plurality of wires 29. The sensing control unit 28 includes an inductive power supply charging module 30, a DC power supply 32, an interactive WiFi connectivity module 34, an operating system electronic module 36, an access electronic module 38, and a scanning sensing electronic input module 40. Among the various modules of the sensing control unit 28, only the inductive power supply charging module 30 is disposed outside the shaft 20 and is stationary, whereas the remaining DC power supply 32 and modules 34, 36, 38, and 40 are disposed inside the shaft 20 at portions outside the processing chamber 18.

In one form, the sensing electronic input module 40 accepts low voltage or current inputs from the temperature sensors 26. The sensing electronic input module 40 input types, cold-junction-compensation, scales, ranges, error reporting, linearization, and calibration offset adjustments are independent per input channel. In one form, each sensing electronic input module 40 can accept up to 16 inputs and make the conditioned and buffered values available to the other modules on the back-plane bus at a 10 Hz update rate. It should be understood that any number of inputs and different update rates may be provided while remaining within the scope of the present disclosure.

The operating system electronic module 36 is an option that is typically used in PLC (Programmable Logic Controller) systems, but is not generally used in its generic form in a distributed-processor system. Typical functions performed may include data acquisition and distribution scheduling, math processing, error and exception handling, HMI (Human Machine Interface) driving, start-up and shut-down management, local-remote access management, local data logging, and multiple communications port access, among others.

The access electronic module 38 in one form is a two-port communications translator that sits (logically, not physically) between a local back-plane data bus and an external "field bus" that communicates bi-directionally with the host computer system for control and data acquisition. Some examples of field bus options would be Modbus serial, Modbus TCP (EtherNET), EtherCAT, DeviceNet, or Profibus. In addition, the access electronic module 38 can hold a copy of the configuration file for every other module on the back-plane bus, to be used for quick and accurate software configuration of replacement modules.

The DC power supply 32 is integrated into the shaft 20 to provide power to the interactive WiFi connectivity module 34, the operating system electronic module 36, the access electronic module 38, and the scanning sensing electronic input module 40 integrated in the shaft 20. The inductive power supply charging module 30 charges the DC power supply 32 by induction.

In still another form, a cooling device or loop 39 is disposed around the shaft 20. This cooling device 39 may take on any number of forms, including a sleeve provided with a cooling fluid, which may be separate or integrated within the shaft 20.

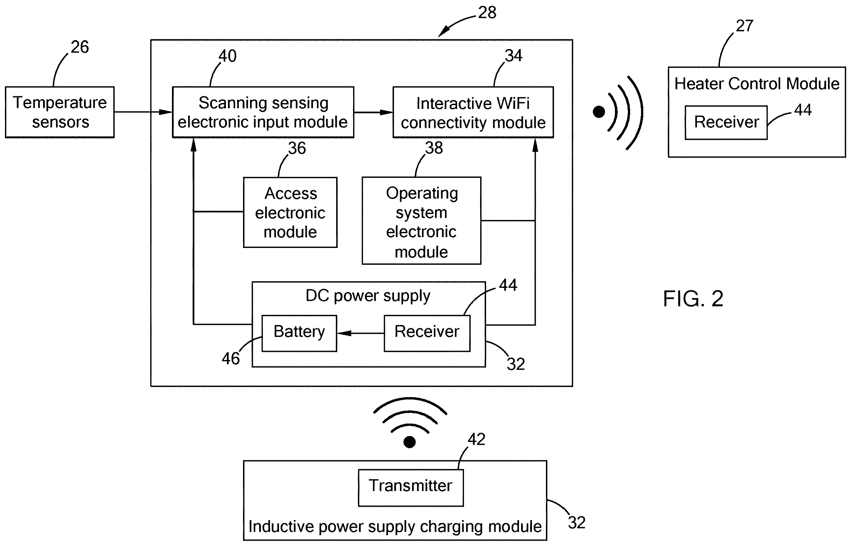

Referring to FIG. 2, the inductive power supply charging module 30 may include a transmitter 42. The DC power supply 32 may include a receiver 44 and a battery 46. As an example, the transmitter 42 and the receiver 44 may be in the form of a first coil and a second coil, respectively. The inductive power supply charging module 30 is disposed proximate the DC power supply 32. The inductive power supply charging module 30 may constantly or periodically activate the first coil, which then creates a magnetic field to induce an electric current in the second coil in the DC power supply 32 to charge the battery 46. As a result, the battery 46 of the DC power supply 32 can be constantly or periodically charged and supply power to the various modules 34, 36, 38 and 40 integrated in the wafer support assembly 12. Alternatively, the power of the battery 46 of the DC power supply 32 may be monitored so that the inductive power supply charging module 30 activates the transmitter 42 to charge the battery 46 when the power of the battery 46 is reduced to a threshold.

The temperature sensors 26 may take any form known in the art, such as thermocouples and are integrated in the wafer support portion 16 to directly measure the temperature of the wafer support portion 16. Therefore, the temperature of the wafer disposed on the wafer support portion 16 can be more accurately measured. The temperature sensors 26 may transmit signals to the scanning sensing electronic input module 40 for signal processing to determine a temperature of the wafer. The access electronic module 36 determines the locations of the temperature sensors that transmit the signals. The operating system electronic module 38 converts the signals relating to the temperature and the signals relating to the locations of the temperature sensors into a wireless packet. The interactive WiFi connectivity module 34 transmits the wireless packet to the heater control module 27 which includes a receiver 44 to receive the wireless packet containing temperature measurement information. The heater control module 27 then controls and adjusts the heat output of the heater 24 based on the temperature measurement information and a desired temperature profile on the wafer.

In the temperature sensing system 14 of the present application, direct temperature sensing is possible by integrating the temperature sensors 26 in the rotating wafer support assembly and by wirelessly transmitting the temperature measurement information to an external heater control module 27. Therefore, the temperature sensing system 14 can more accurately measure the temperature of the wafer. No wirings are used to transmit the temperature measurement signals to an external control module 27.

## Claims

1. A semiconductor processing apparatus (10), comprising:
a wafer support assembly (12);
a plurality of temperature sensors (26) integrated in the wafer support assembly (12) and rotatable with the wafer support assembly (12) for measuring temperatures of the wafer support assembly (12); and
a sensing control unit (28) configured to receive first signals from the temperature sensors (26) relating the temperatures of the wafer support assembly (12), determine locations of the temperature sensors (26) based on the first signals, and convert the first signals relating the temperatures of the wafer support assembly (12) and second signals relating to the locations of the temperature sensors (26) into a wireless packet,
wherein the sensing control unit (28) includes a signal transmission device (34) integrated in the wafer support assembly (12) and rotatable with the wafer support assembly (12) for wirelessly transmitting the wireless packet to an external control module (27).

2. The semiconductor processing apparatus (10) according to Claim 1, wherein the signal transmission device (34) is disposed inside a shaft (20) of the wafer support assembly (12).

3. The semiconductor processing apparatus (10) according to Claim 1, wherein the signal transmission device (34) includes an interactive WiFi connectivity module (34).

4. The semiconductor processing apparatus (10) according to Claim 1, further comprising a DC power supply (32) integrated in the wafer support assembly (12), and an inductive power supply charging module (30) disposed outside the wafer support assembly (12).

5. The semiconductor processing apparatus (10) according to Claim 4, wherein the inductive power supply charging module (30) includes a first coil, and the DC power supply (32) includes a second coil, the first coil generating a magnetic field to induce an electric current in the second coil.

6. The semiconductor processing apparatus (10) according to Claim 1, further comprising a sensing electronic input module (40) integrated in the wafer support assembly (12).

7. The semiconductor processing apparatus (10) according to Claim 1, wherein the wafer support assembly (12) includes a wafer support portion (16) and a shaft (20) connected to the wafer support portion (16), wherein the temperature sensors (26) are disposed in the wafer support portion (16), and the signal transmission device (34) is disposed in the shaft (20).

8. The semiconductor processing apparatus (10) according to Claim 7, further comprising a heater (24) disposed under the wafer support portion (16) of the wafer support assembly (12).

9. The semiconductor processing apparatus (10) according to Claim 7, wherein the wafer support assembly (12) is rotatable.

10. The semiconductor processing apparatus (10) according to Claim 1, wherein the external control module (27) is a heater control module (27) that controls a heater (24) based on the temperature measurement.

11. The semiconductor processing apparatus (10) according to Claim 1, further comprising at least one of a scanning sensing electronic input module (40), an access electronic module (38), and an operating system electronic module (36).

12. A semiconductor processing system comprising a processing chamber (18) and a semiconductor processing apparatus (10) according to Claim 1.

13. The semiconductor processing system according to Claim 12, wherein the wafer support assembly (12) includes a wafer support portion (16) disposed inside the processing chamber (18) and a shaft (20) connected to the wafer support portion (16) and extending through a wall (22) of the processing chamber (18).

14. The semiconductor processing system according to Claim 13 further comprising a cooling device (39) disposed around the shaft (20).

## Patentansprüche

1. Halbleiterverarbeitungseinrichtung (10), umfassend:
eine Wafer-Trägeranordnung (12);
eine Vielzahl von Temperatursensoren (26), die in der Wafer-Trägeranordnung (12) integriert sind, und mit der Wafer-Trägeranordnung (12) drehbar sind, um Temperaturen der Wafer-Trägeranordnung (12) zu messen; und
eine Erfassungssteuerungseinheit (28), die konfiguriert ist, um erste Signale von den Temperatursensoren (26) in Bezug auf die Temperaturen der Wafer-Trägeranordnung (12) zu empfangen, Stellen der Temperatursensoren (26) basierend auf den ersten Signalen zu bestimmen, und die ersten Signale in Bezug auf die Temperaturen der Wafer-Trägeranordnung (12) und zweite Signale in Bezug auf die Stellen der Temperatursensoren (26) in ein drahtloses Paket umzuwandeln,
wobei die Erfassungssteuerungseinheit (28) eine Signalübertragungsvorrichtung (34) beinhaltet, die in der Wafer-Trägeranordnung (12) integriert ist, und mit der Wafer-Trägeranordnung (12) drehbar sind, um drahtlos das drahtlose Paket an ein externes Steuerungsmodul (27) zu übertragen.

2. Halbleiterverarbeitungseinrichtung (10) nach Anspruch 1, wobei die Signalübertragungsvorrichtung (34) innerhalb einer Welle (20) der Wafer-Trägeranordnung (12) angeordnet ist.

3. Halbleiterverarbeitungseinrichtung (10) nach Anspruch 1, wobei die Signalübertragungsvorrichtung (34) ein interaktives WLAN-Verbindungsmodul (34) beinhaltet.

4. Halbleiterverarbeitungseinrichtung (10) nach Anspruch 1, weiter eine DC-Leistungsversorgung (32) umfassend, die in der Wafer-Trägeranordnung (12) integriert ist, und ein induktives Leistungsversorgungslademodul (30), das außerhalb der Wafer-Trägeranordnung (12) angeordnet ist.

5. Halbleiterverarbeitungseinrichtung (10) nach Anspruch 4, wobei das induktive Leistungsversorgungslademodul (30) eine erste Spule beinhaltet, und die DC-Leistungsversorgung (32) eine zweite Spule beinhaltet, wobei die erste Spule ein Magnetfeld generiert, um einen elektrischen Strom in der zweiten Spule zu induzieren.

6. Halbleiterverarbeitungseinrichtung (10) nach Anspruch 1, weiter ein elektronisches Eingangserfassungsmodul (40) umfassend, das in der Wafer-Trägeranordnung (12) integriert ist.

7. Halbleiterverarbeitungseinrichtung (10) nach Anspruch 1, wobei die Wafer-Trägeranordnung (12) einen Wafer-Trägerabschnitt (16) und eine Welle (20) beinhaltet, die mit dem Wafer-Trägerabschnitt (16) verbunden ist, wobei die Temperatursensoren (26) im Wafer-Trägerabschnitt (16) angeordnet sind, und die Signalübertragungsvorrichtung (34) in der Welle (20) angeordnet ist.

8. Halbleiterverarbeitungseinrichtung (10) nach Anspruch 7, weiter einen Heizer (24) umfassend, der unter dem Wafer-Trägerabschnitt (16) der Wafer-Trägeranordnung (12) angeordnet ist.

9. Halbleiterverarbeitungseinrichtung (10) nach Anspruch 7, wobei die Wafer-Trägeranordnung (12) drehbar ist.

10. Halbleiterverarbeitungseinrichtung (10) nach Anspruch 1, wobei das externe Steuerungsmodul (27) ein Heizer-Steuerungsmodul (27) ist, das einen Heizer (24) basierend auf der Temperaturmessung steuert.

11. Halbleiterverarbeitungseinrichtung (10) nach Anspruch 1, weiter mindestens eines von einem elektronischen Scaneingangserfassungsmodul (40), einem elektronischen Zugriffsmodul (38) und einem elektronischen Betriebssystemmodul (36) umfassend.

12. Halbleiterverarbeitungssystem, eine Verarbeitungskammer (18) und eine Halbleiterverarbeitungseinrichtung (10) nach Anspruch 1 umfassend.

13. Halbleiterverarbeitungssystem nach Anspruch 12, wobei die Wafer-Trägeranordnung (12) einen Wafer-Trägerabschnitt (16) beinhaltet, der innerhalb der Verarbeitungskammer (18) angeordnet ist, und eine Welle (20), die mit dem Wafer-Trägerabschnitt (16) verbunden ist, und sich durch eine Wand (22) der Verarbeitungskammer (18) erstreckt.

14. Halbleiterverarbeitungssystem nach Anspruch 13, weiter eine Kühlvorrichtung (39) umfassend, die um die Welle (20) herum angeordnet ist.

## Revendications

1. Appareil de traitement de semi-conducteur (10), comprenant :
un ensemble de support de tranche (12) ;
une pluralité de capteurs de température (26) intégrés dans l'ensemble de support de tranche (12) et pouvant tourner avec l'ensemble de support de tranche (12) pour mesurer les températures de l'ensemble de support de tranche (12) ; et
une unité de commande de détection (28) configurée pour recevoir des premiers signaux des capteurs de température (26) relatifs aux températures de l'ensemble de support de tranche (12), déterminer les emplacements des capteurs de température (26) sur la base des premiers signaux, et convertir les premiers signaux relatifs aux températures de l'ensemble de support de tranche (12) et des deuxièmes signaux relatifs aux emplacements des capteurs de température (26) en un paquet sans fil,
dans lequel l'unité de commande de détection (28) comporte un dispositif de transmission de signaux (34) intégré dans l'ensemble de support de tranche (12) et pouvant tourner avec l'ensemble de support de tranche (12) pour transmettre sans fil le paquet sans fil à un module de commande externe (27).

2. Appareil de traitement de semi-conducteur (10) selon la revendication 1, dans lequel le dispositif de transmission de signaux (34) est disposé à l'intérieur d'un arbre (20) de l'ensemble de support de tranche (12).

3. Appareil de traitement de semi-conducteur (10) selon la revendication 1, dans lequel le dispositif de transmission de signaux (34) comporte un module de connectivité WiFi interactive (34).

4. Appareil de traitement de semi-conducteur (10) selon la revendication 1, comprenant en outre une alimentation en courant continu (32) intégrée dans l'ensemble de support de tranche (12) et un module de charge d'alimentation inductive (30) disposé à l'extérieur de l'ensemble de support de tranche (12).

5. Appareil de traitement de semi-conducteur (10) selon la revendication 4, dans lequel le module de charge d'alimentation inductive (30) comporte une première bobine, et l'alimentation en courant continu (32) comporte une deuxième bobine, la première bobine générant un champ magnétique pour induire un courant électrique dans la deuxième bobine.

6. Appareil de traitement de semi-conducteur (10) selon la revendication 1, comprenant en outre un module d'entrée électronique de détection (40) intégré dans l'ensemble de support de tranche (12).

7. Appareil de traitement de semi-conducteur (10) selon la revendication 1, dans lequel l'ensemble de support de tranche (12) comporte une partie de support de tranche (16) et un arbre (20) relié à la partie de support de tranche (16), dans lequel les capteurs de température (26) sont disposés dans la partie de support de tranche (16), et le dispositif de transmission de signaux (34) est disposé dans l'arbre (20).

8. Appareil de traitement de semi-conducteur (10) selon la revendication 7, comprenant en outre un élément chauffant (24) disposé sous la partie de support de tranche (16) de l'ensemble de support de tranche (12).

9. Appareil de traitement de semi-conducteur (10) selon la revendication 7, dans lequel l'ensemble de support de tranche (12) peut tourner.

10. Appareil de traitement de semi-conducteur (10) selon la revendication 1, dans lequel le module de commande externe (27) est un module de commande d'élément chauffant (27) qui commande un élément chauffant (24) sur la base de la mesure de température.

11. Appareil de traitement de semi-conducteur (10) selon la revendication 1, comprenant en outre au moins l'un d'un module d'entrée électronique de détection de balayage (40), d'un module électronique d'accès (38) et d'un module électronique de système d'exploitation (36).

12. Système de traitement de semi-conducteur comprenant une chambre de traitement (18) et un appareil de traitement de semi-conducteur (10) selon la revendication 1.

13. Système de traitement de semi-conducteur selon la revendication 12, dans lequel l'ensemble de support de tranche (12) comporte une partie de support de tranche (16) disposée à l'intérieur de la chambre de traitement (18) et un arbre (20) relié à la partie de support de tranche (16) et s'étendant à travers une paroi (22) de la chambre de traitement (18).

14. Système de traitement de semi-conducteur selon la revendication 13, comprenant en outre un dispositif de refroidissement (39) disposé autour de l'arbre (20).
